# EUROPEAN PATENT APPLICATION

(11) **EP 4 691 842 A1**
(43) Date of publication of application: **11.02.2026**
(21) Application number: 23931821.5
(22) Date of filing: 07.12.2023
(51) Int. Cl.: B60L 58/12, B60R 16/023

(54) **BATTERY MANAGEMENT SYSTEM COMMUNICATION METHOD, BATTERY MANAGEMENT SYSTEM, ELECTRONIC DEVICE, AND MEDIUM**

(30) Priority: 07.04.2023 CN 202320769713 U; 07.04.2023 CN 202310373057
(71) Applicant: Eve Energy Co., Ltd., Huizhou, Guangdong 516006 (CN)
(72) Inventor: XIE, Yongye, Huizhou, Guangdong 516006 (CN); ZHENG, Jian, Huizhou, Guangdong 516006 (CN); JIANG, Jibing, Huizhou, Guangdong 516006 (CN)
(74) Representative: Berggren Oy
(86) International application number: PCT/CN2023/137286
(87) International publication number: WO 2024/207776

(57) **Abstract**

A communication method for a battery management system (BMS), a BMS, an electronic device, and a medium. The communication method for the BMS includes receiving battery status information from a cell supervision circuit (CSC); performing enhancement processing on the battery status information to obtain enhanced battery status information; and transmitting the enhanced battery status information to a battery management unit (BMU) so that the BMU controls the operating condition of a battery based on the enhanced battery status information.

## Description

This application claims the priority to and benefit of Chinese Patent Application No. 202310373057.5 and 202320769713.9, both filed with China Patent Office on April 7, 2023, the entire contents of which is incorporated herein by reference.

### TECHNICAL FIELD

The invention relates to the technical field of batteries, for example, to a communication method for a battery management system (BMS), a BMS, an electronic device, and a medium.

### BACKGROUND

In related technologies, when a vehicle is equipped with multiple battery casings, the battery management unit (BMU) and cell supervision circuit (CSC) of the BMS cannot be installed in the same area due to the limited layout of the entire vehicle and the differences in the external dimensions of the battery casings. The communication wiring harness between the BMU and the CSC can be excessively long, which may easily lead to signal distortion.

### SUMMARY

The invention provides a communication method for a BMS, a BMS, an electronic device and a medium, which can solve the above-mentioned technical problems.

To achieve the above objectives, the invention adopts the following technical solutions.

In a first aspect, an embodiment of the invention provides a communication method for a BMS, applicable to a relay unit of the BMS. The BMS also includes at least one CSC and a BMU. The at least one CSC, the BMU, and the relay unit are connected to a same communication network. The communication method for the BMS includes:
receiving battery status information from the at least one CSC;
performing enhancement processing on the battery status information to obtain enhanced battery status information; and
transmitting the enhanced battery status information to the BMU, so that the BMU controls the operating condition of a battery based on the enhanced battery status information.

In a second aspect, an embodiment of the invention also provides another communication method for a BMS, applicable to a relay unit of a BMS. The BMS also includes at least one CSC and a BMU. The at least one CSC, the BMU, and the relay unit are connected to a same communication network. The communication method for the BMS includes:
receiving instruction information from the BMU;
performing enhancement processing on the instruction information to obtain enhanced instruction information;
transmitting the enhanced instruction information to the at least one CSC, so that the at least one CSC executes the enhanced instruction information.

In a third aspect, an embodiment of the invention further provides a BMS, including:
at least one CSC, configured to acquire battery status information and connected to a communication network;
a BMU, configured to control an operating condition of a battery based on the battery status information, and connected to the communication network;
a relay unit, connected to the communication network and disposed between the BMU and the at least one CSC, and configured to implement the above-mentioned communication method for the BMS.

In a fourth aspect, an embodiment of the invention further provides an electronic device including a memory and a processor. The memory stores an application program, and the processor is configured to execute the application program in the memory to implement the communication method for the BMS.

In a fifth aspect, an embodiment of the invention further provides a medium storing a plurality of instructions, which are suitable for loading by a processor to execute the operations in the communication method for the BMS.

### BENEFICIAL EFFECTS

The beneficial effects of the invention are as follows: a communication method for the BMS provided by the invention performs enhancement processing on the battery status information transmitted between the CSC and the BMU through a relay unit. The enhancement reduces the attenuation of information during the transmission process, extends the transmission distance between the CSC and the BMU within the communication network, and alleviates the problem of signal distortion caused by the excessively long communication wiring harness between the BMU and the CSC.

Another communication method for the BMS provided by the invention performs enhancement processing on the instruction information transmitted between the CSC and the BMU through the relay unit. The enhancement reduces the attenuation of information during the transmission process, extends the transmission distance between the CSC and the BMU within the communication network, and alleviates the problem of signal distortion caused by the excessively long communication wiring harness between the BMU and the CSC.

A BMS provided in the invention is configured to implement the communication method for the BMS, which performs enhancement processing on the information transmitted between the CSC and the BMU through the relay unit, reduces the attenuation of information during the transmission process, extends the transmission distance between the CSC and the BMU within the communication network, and alleviates the problem of signal distortion caused by the communication wiring harness between the BMU and the CSC being excessively long.

An electronic device provided by the invention includes a memory and a processor. The memory stores an application program, and the processor is configured to execute the application program in the memory to implement the communication method for the BMS, and enhances the information transmitted between the CSC and the BMU through the relay unit to reduce the attenuation of information during the transmission process, thereby extending the transmission distance between the CSC and the BMU within the communication network, and alleviating the problem of signal distortion caused by the communication harness between the BMU and the CSC being excessively long.

A medium provided by the invention stores multiple instructions, which are suitable for loading by a processor to implement the communication method for the BMS which enhances the information transmitted between the CSC and the BMU through the relay unit, reduces the attenuation of information during the transmission process, extends the transmission distance between the CSC and the BMU within the communication network, and alleviates the problem of signal distortion caused by the communication wiring harness between the BMU and the CSC being excessively long.

### BRIEF DESCRIPTION OF THE DRAWINGS

FIG. 1 is a schematic diagram of the architecture of a BMS according to an embodiment of the invention.
FIG. 2 is a flowchart of a communication method for the BMS according to an embodiment of the invention.
FIG. 3 is a second flowchart of a communication method for the BMS according to an embodiment of the invention.
FIG. 4 is a schematic diagram showing the structure of a relay unit according to an embodiment of the invention.
FIG. 5 is an exploded view of the structure of the relay unit according to an embodiment of the invention.
FIG. 6 is a front view of the relay unit according to an embodiment of the invention.
FIG. 7 is a rear view of the relay unit according to an embodiment of the invention.
FIG. 8 is a left side view of the relay unit according to an embodiment of the invention.
FIG. 9 is a right side view of the relay unit according to an embodiment of the invention.
FIG. 10 is a top view of the relay unit according to an embodiment of the invention.
FIG. 11 is a bottom view of the relay unit according to an embodiment of the invention.

### List of reference numerals:

1. Relay unit; 11. Casing; 111. Housing; 112. Cover; 12. Repeater; 13. Connector; 131. First connector; 132. Second connector; 14. Fixing seat; 141. Fixing and connecting hole; 15. Seal; 2. CSC; 3. BMU; 4. Load carrier.

### DETAILED DESCRIPTION OF THE EMBODIMENTS

In the invention, unless otherwise specified, directional words such as "upper" and "lower" typically refer to the upper and lower parts of the device in actual use or working state, specifically the direction of the drawings in the accompanying drawings; while "inside" and "outside" are relative to the outline of the device.

In the description of the invention, it should be noted that, unless otherwise clearly specified and limited, the terms "installed", "connected" and "coupled" should be understood in a broad sense. For example, it can be a fixed connection, a detachable connection, or an integral connection; it can be a mechanical connection, an electrical connection or mutual communication; it can be directly connected or indirectly connected through an intermediate medium, and it can be the internal connection of two elements or the interaction relationship between two elements.

In related technologies, when a vehicle is equipped with multiple battery casings, the BMU and CSC of the BMS cannot be installed in the same area due to the limited layout of the entire vehicle and the differences in the external dimensions of the battery casings. The communication wiring harness between the BMU and the CSC may be excessively long, which can easily lead to signal distortion.

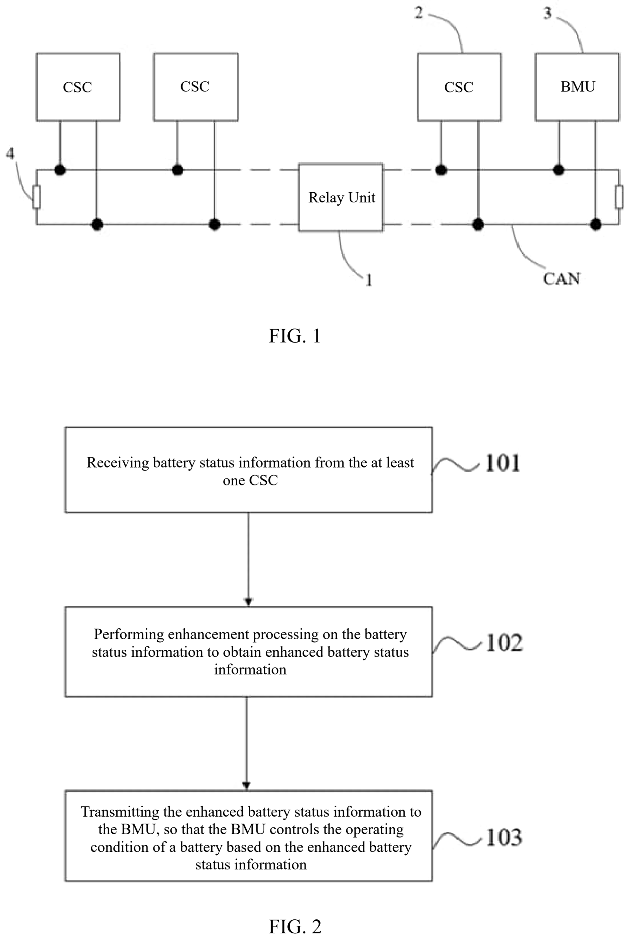

In one aspect, the embodiment of the invention provides a communication method for the BMS. As shown in FIG. 1, the communication method for the BMS may be applicable to a relay unit 1 in a BMS. The BMS also includes at least one CSC 2 and a BMU 3. The at least one CSC 2, the BMU 3, and the relay unit 1 are connected to the same communication network. The communication network may be a CAN (Controller Area Network). The CSC 2 is configured to acquire battery status information, for example, related to temperature and voltage of the battery modules in the battery casing. The BMU 3 is configured to process and analyze the battery status information acquired by the at least one CSC 2 and then send control instructions to the at least one CSC 2, the battery modules, and other related components to maintain normal operating conditions of the battery modules. The relay unit 1 is disposed in the middle of the CAN.

The BMS of this embodiment typically includes one BMU 3 and multiple CSCs 2. Each CSC 2 monitors the status information of one battery module respectively. Multiple battery modules correspond to the multiple CSCs 2.

The communication method for the BMS of this embodiment is implemented by the relay unit 1, as shown in FIG. 2, and includes operations 101, 102 and 103 as follows.

Operation 101 may include receiving battery status information from the at least one CSC 2; wherein the battery status information includes but is not limited to at least one of the following information: temperature of a battery module, voltage of a battery module, and the like.

Operation 102 may include performing enhancement processing on the battery status information to obtain enhanced battery status information.

In one embodiment, operation 102 may include filtering and/or amplifying the battery status information to obtain filtered and/or amplified battery status information.

In this way, the battery status information transmitted from the CSCs 2 is enhanced by the relay unit 1, the signal quality is improved, the signal is not distorted, the effect of extending the communication network is achieved, and the effective communication distance is extended.

In one embodiment, operation 102 may include adjusting the baud rate of the enhanced battery status information so that the baud rate of the enhanced battery status information is adapted to the communication network.

In this way, the relay unit 1 can adapt the battery status information to communication networks with different communication baud rates, enabling smooth switching between the CAN and the CANFD (Controller Area Network with Flexible Data-Rate), thus ensuring normal communication between the BMU 3 and the CSCs 2. The CANFD is an upgrade and improvement of the CAN.

Operation 103 may include transmitting the enhanced battery status information to the at least one BMU 3, so that the BMU 3 can control the operating condition of a battery based on the enhanced battery status information.

After the enhancement processing performed by the relay unit 1, the enhanced battery status information may avoid the occurrence of signal power attenuation, signal distortion, etc. The BMU 3 can receive accurate and reliable battery status information, preventing the BMU 3 from receiving erroneous messages, causing erroneous judgments, and issuing erroneous instructions, which will cause safety hazards to the vehicle's battery system.

In one embodiment, after operation 101, the communication method for the BMS further includes the following operations:
acquiring a signal power of the battery status information; and
determining whether to perform enhancement processing on the battery status information based on the signal power of the battery status information.

Assuming that the signal power of the battery status information is P1 and a first threshold is Pth1, where the first threshold is a preset signal power constant value used to determine whether to perform enhancement processing on the battery status information. The magnitude relationship between the signal power P1 of the battery status information and the first threshold Pth1 is compared as follows:
if P1 < Pth1, it is determined that the current battery status information has a serious signal attenuation and a risk of signal distortion, and needs to be enhanced, then the process goes to operation 102;
if P1 ≥ Pth1, it is determined that the current battery status information is normal and does not require enhancement processing, and the battery status information is directly transmitted to the BMU 3.

The communication method for the BMS of this embodiment first receives battery status information from the CSC 2; then performs enhancement processing on the battery status information to obtain enhanced battery status information; and finally transmits the enhanced battery status information to BMU 3, so that BMU 3 controls the operating condition of the battery based on the enhanced battery status information. In this embodiment, the relay unit 1 enhances the information transmitted between the CSC 2 and BMU 3, reducing information attenuation during transmission and extending the transmission distance between CSC 2 and BMU 3 within the communication network. This alleviates the problem of signal distortion caused by the excessively long communication wiring harness between BMU 3 and battery monitoring unit 2.

An embodiment of the invention provides another communication method for the BMS, which is applied to a relay unit 1 of a BMS. The BMS also includes at least one CSC 2 and a BMU 3. The at least one CSC 2, the BMU 3, and the relay unit 1 are connected to the same communication network. The communication network may be a CAN. The CSC 2 is configured to acquire battery status information such as related to the temperature and voltage of the battery module. The BMU 3 is configured to process and analyze the battery status information acquired by the at least one CSC 2, and then send control instructions to the at least one CSC 2, the battery modules, and other related components to keep the battery modules in normal operating condition. The relay unit 1 is arranged in the middle of the CAN.

The BMS of this embodiment typically includes a BMU 3 and multiple CSCs 2. Each CSC 2 is configured to monitor the status information of one battery module respectively. Multiple battery modules correspond to multiple CSCs 2.

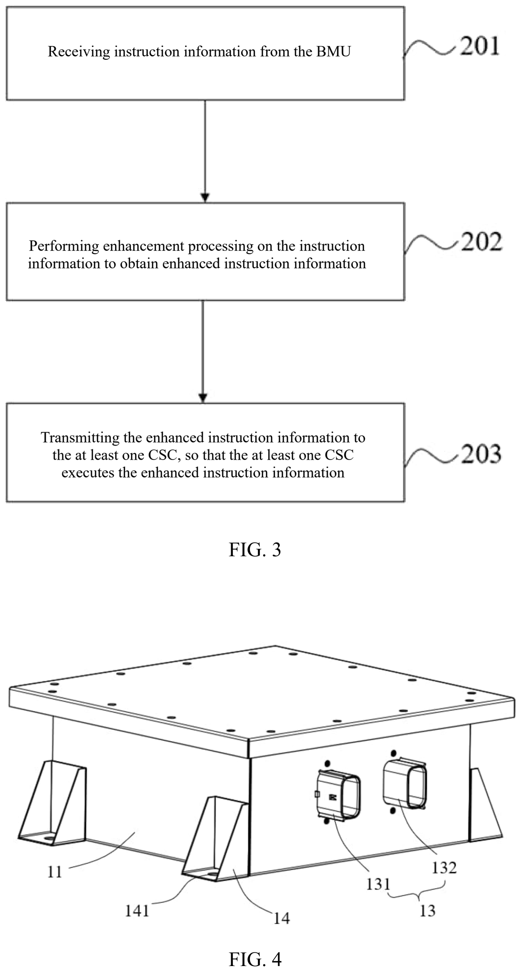

The communication method for the BMS of this embodiment is performed by the relay unit 1, as shown in FIG. 3, and includes operations 201, 202, and 203 as follows.

Operation 201 may include receiving instruction information from the BMU 3.

Operation 202 may include performing enhancement processing on the instruction information to obtain enhanced instruction information.

In one embodiment, operation 202 may include filtering and/or amplifying the instruction information to obtain filtered and/or amplified instruction information.

In this way, the instruction information transmitted from the BMU 3 is enhanced by the relay unit 1, the signal quality is improved, the signal is not distorted, the effect of extending the communication network is achieved, and the effective communication distance is extended.

In one embodiment, operation 202 further includes: adjusting the baud rate of the enhanced instruction information so that the baud rate of the enhanced instruction information is adapted to the communication network.

In this way, the relay unit 1 can adapt the instruction information to communication networks with different communication baud rates, allowing for smooth switching between the CAN and the CANFD, ensuring normal communication between the BMU 3 and the CSC 2. The CANFD is an upgrade and improvement of the CAN.

Operation 203 may include transmitting the enhanced instruction information to the at least one CSC 2, so that the at least one CSC 2 executes the enhanced instruction information.

After the enhancement processing performed by the relay unit 1, the enhanced instruction information may avoid the occurrence of signal power attenuation, signal distortion, etc., and the CSC 2 can receive accurate and authentic instruction information, preventing the CSC 2 from receiving incorrect commands and performing incorrect operations, which may cause safety hazards to the vehicle's battery system.

In one embodiment, after operation 201, the communication method for the BMS further includes the following operations:
acquiring the signal power of the instruction information; and
determining whether to perform enhancement processing on the instruction information based on the signal power of the instruction information.

Assuming that the signal power of the instruction information is P2 and a second threshold is Pth2, where the second threshold is also a preset signal power constant value used to determine whether to perform enhancement processing on the instruction information. The magnitude relationship between the signal power P2 of the instruction information and the second threshold Pth2 is compared as follows:
if P2 < Pth2, it is determined that the current instruction information has serious signal attenuation and signal distortion, and needs to be enhanced, then the process goes to operation 202;
if P2 ≥ Pth2, it is determined that the current instruction information is normal and does not require enhancement processing, and the instruction information is directly transmitted to the CSC 2.

The communication method for the BMS of this embodiment first receives instruction information from the BMU 3; then performs enhancement processing on the instruction information to obtain enhanced instruction information; and finally transmits the enhanced instruction information to the CSC 2, so that the CSC 2 executes the enhanced instruction information. In this embodiment, the relay unit 1 enhances the information transmitted between the CSC 2 and the BMU 3, reducing information attenuation during transmission and extending the transmission distance between the CSC 2 and the BMU 3 within the communication network. This alleviates the problem of signal distortion caused by the excessively long communication wiring harness between the BMU 3 and the CSC 2.

The invention also provides a BMS that is applied to the communication method for the BMS provided in the above embodiment. As shown in FIG. 1, the BMS includes at least one CSC 2, a BMU 3, and a relay unit 1. The CSC 2 is configured to acquire battery status information and is connected to a communication network. The BMU 3 is configured to control the operating status of the battery based on the battery status information and is connected to the communication network. The relay unit 1 is connected to the communication network and disposed between the BMU 3 and the CSC 2 to enhance the information transmitted between the BMU 3 and the CSC 2.

In the BMS of this embodiment, the relay unit 1 performs enhancement processing on the information transmitted between the CSC 2 and the BMU 3, reduces the attenuation of information during the transmission process, extends the transmission distance between the CSC 2 and the BMU 3 within the communication network, and alleviates the problem of signal distortion caused by the communication wiring harness between the BMU 3 and the CSC 2 being excessively long.

In one embodiment, the relay unit 1 is disposed in the middle section of the communication network. This facilitates the wiring arrangement between the CSC 2 and the BMU 3 within the communication network, improves the relaying effect of the relay unit 1, and prevents signal distortion in the communication between the CSC 2 and the BMU 3 due to the undue communication distance.

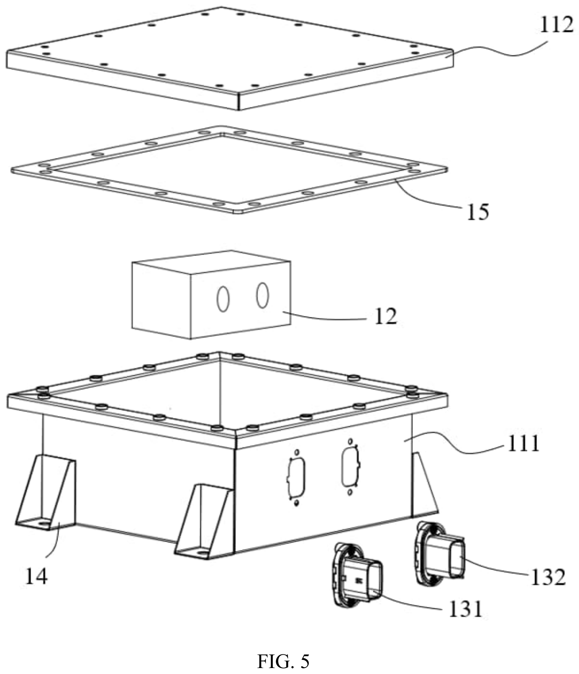

In one embodiment, as shown in FIGs. 4 and 5, the relay unit 1 includes a casing 11 and a repeater 12. The repeater 12 is disposed within the casing 11 and is connected to the communication network. The casing 11 can be a low-voltage casing, which provides good protection for the repeater 12, ensuring its normal operation and ensuring the relay effectiveness of the repeater 12, enabling stable performance of enhancement processing on the information transmitted between the CSC 2 and the BMU 3.

In one embodiment, the relay unit 1 further includes a connector 13 arranged on the casing 11. One end of the connector 13 is connected to the repeater 12, and the other end is connected to the communication network. The connection of the connector 13 enables a stable connection between the repeater 12 and the communication network.

In one embodiment, the connector 13 includes a first connector 131 and a second connector 132. One end of the first connector 131 is connected to the repeater 12, and the other end of the first connector 131 is connected to the communication network. One end of the second connector 132 is disconnected from the repeater 12, and the other end of the second connector 132 is connected to the communication network.

In this way, the need for a relay effect can be determined based on actual conditions. When the relay unit 1 is required to perform signal amplification between the CSC 2 and the BMU 3, the repeater 12 can be connected to the communication network via the first connector 131. When the relay unit 1 is not required to perform signal amplification between the CSC 2 and the BMU 3, the communication network is directly connected to the second connector 132, and the repeater 12 is not connected to the communication network.

In one embodiment, the IP (Ingress Protection) rating of the connector 13 reaches IP68 or above, which can completely prevent the intrusion of external dust, prevent the intrusion of water when sinking, and prevent the impact of continuous immersion in water with a depth of more than one meter.

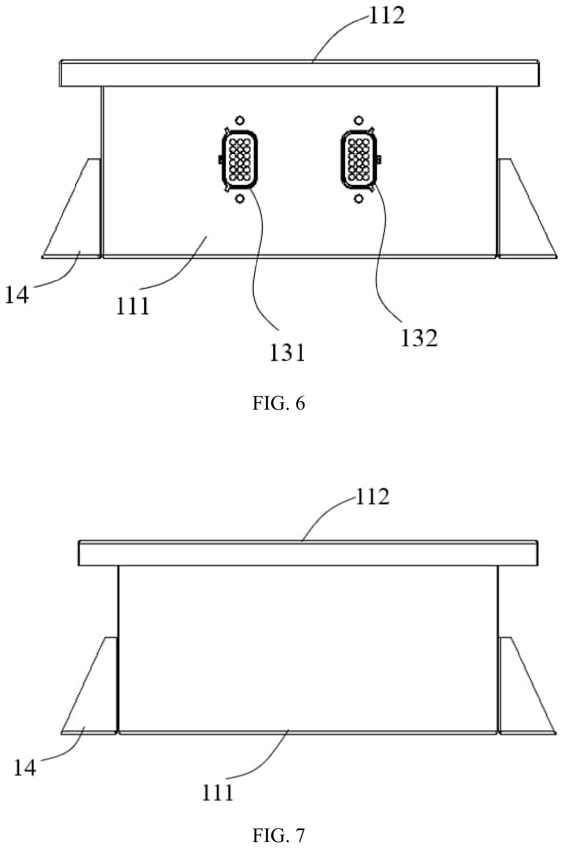

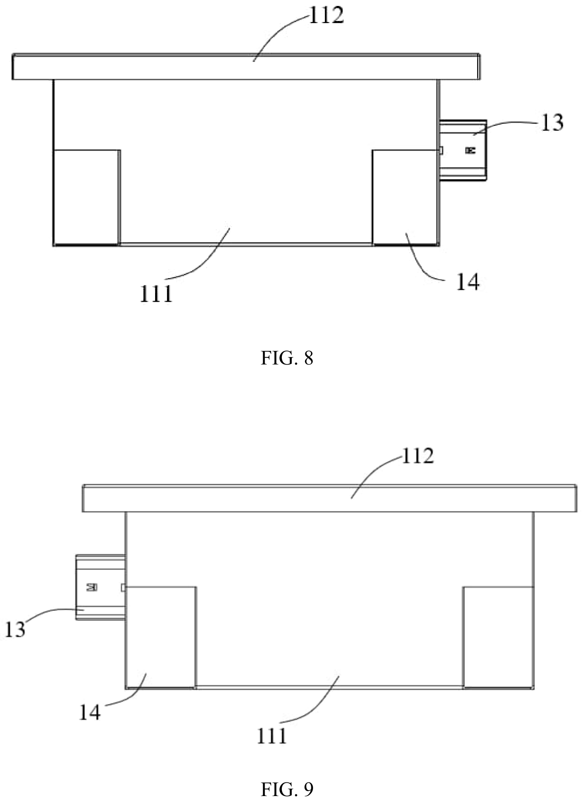

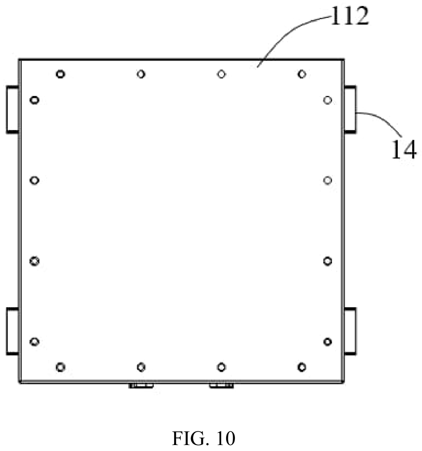

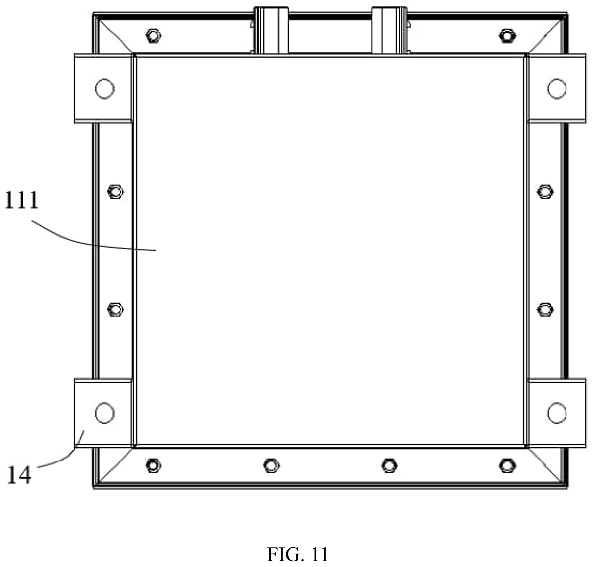

In one embodiment, as shown in FIGs. 6 to 11, the casing 11 includes a housing 111 and a cover 112. The cover 112 is sealed to the housing 111 via a seal 15. The seal 15 may be a sealing strip made of rubber. The IP rating of the casing 11 is no less than IP67, meaning that it is completely protected from external dust intrusion and water ingress during immersion, and is resistant to immersion in water up to a depth of one meter for 30 minutes. This ensures that the repeater 12 can operate in a relatively safe and stable environment.

In one embodiment, the cover 112 is fixedly connected to the housing 111 by a fixing member. The fixing member can be a bolt, which can ensure the overall strength of the casing 11, can withstand a certain impact force, and provide better protection for the repeater 12.

In some examples, the housing 111 is formed by folding and welding sheet metal. The cover 112 and the housing 111 are fixed by bolts, and the sealing strip is squeezed by the cover 112 and the housing 111, thereby eliminating the gap between the cover 112 and the housing 111 and achieving IP requirements.

In one embodiment, the casing 11 further includes a fixing seat 14, which is connected to the bottom of the housing 111 and is provided with a fixing and connecting hole 141. The fixing seat 14 can be securely connected to the vehicle by the engagement of bolts with the fixing and connecting hole 141, thereby preventing the casing 11 from shifting while the vehicle is in motion.

In one embodiment, the BMS further includes a load carrier 4, which is arranged in the communication network and is configured to stabilize the voltage of the communication network, thereby reducing fluctuations in the communication network.

The resistance value of the load carrier 4 may range from 100 ohms to 200 ohms, for example, 120 ohms, 150 ohms, etc. This can effectively reduce fluctuations in the communication network.

The specific operating method of the BMS of this embodiment is as follows.

First, the relay unit 1 receives battery status information from the CSC 2; wherein the battery status information includes but is not limited to at least one of the temperature, voltage and other information of the battery module.

Then, the relay unit 1 performs enhancement processing on the battery status information to obtain enhanced battery status information. In some examples, the relay unit 1 may filter and/or amplify the battery status information to obtain filtered and/or amplified battery status information. In this way, the battery status information transmitted from CSC 2 is enhanced by the relay unit 1, improving signal quality and preventing signal distortion, thereby extending the communication network and extending the effective communication distance. Simultaneously, the relay unit 1 adjusts the baud rate of the enhanced battery status information to adapt to that of the communication network.

Finally, the relay unit 1 transmits the enhanced battery status information to the BMU 3, so that the BMU 3 controls the operating condition of the battery based on the enhanced battery status information.

On the other hand, the specific working method of the BMS can also be as follows.

First, the relay unit 1 receives instruction information from the BMU 3.

Then, the relay unit 1 enhances the instruction information to obtain enhanced instruction information. In some examples, the instruction information may be filtered and/or amplified to obtain filtered and/or amplified instruction information. In this way, the instruction information transmitted from the BMU 3 is enhanced by the relay unit 1, improving the signal quality and preventing signal distortion, thereby achieving the effect of extending the communication network and extending the effective communication distance. Furthermore, the relay unit 1 adjusts the baud rate of the enhanced instruction information to adapt to the baud rate of the communication network.

Finally, the relay unit 1 transmits the enhanced instruction information to the CSC 2, so that the CSC 2 executes the enhanced instruction information.

The BMS of this embodiment implements the communication method for the BMS provided in the above embodiment, and enhances the information transmitted between the CSC 2 and the BMU 3 through the relay unit 1, thereby reducing the attenuation of information during the transmission process, extending the transmission distance between the CSC 2 and the BMU 3 within the communication network, and alleviating the problem of signal distortion caused by the communication wiring harness between the BMU 3 and the CSC 2 being excessively long.

Accordingly, an embodiment of the invention further provides an electronic device, which may be a computer or other device such as a server/terminal. The electronic device may include components such as a radio frequency (RF) circuit, a memory including one or more computer-readable storage media, an input unit, a display unit, a sensor, an audio circuit, a WiFi module, a processor including one or more processing cores, and a power supply.

The RF circuit is configured to receive and transmit signals during messaging or calls. In some examples, the RF circuit may be configured to receive downlink information from the base station and pass it to one or more processors for processing. Furthermore, the RF circuit is configured to transmit uplink data to the base station. The memory may be configured to store software programs and modules. The processor is configured to execute the software programs and modules stored in the memory to execute various functional application programs and virtual machine backups. The input unit may be configured to receive digital or character input and generate keyboard, mouse, joystick, optical, or trackball signal input related to user settings and function control.

The display unit may be configured to display information input by the client or information provided to the client and various graphic client interfaces of the server. These graphical user interfaces may be composed of graphics, texts, icons, videos and a combination thereof.

The electronic device may further include at least one sensor, such as a light sensor, a motion sensor, or other sensors. The audio circuit may include a speaker, which may provide an audio interface between the user and the electronic device.

WiFi is a short-range wireless transmission technology. Electronic devices can help customers send and receive emails, browse web pages, and follow streaming media through WiFi modules. It provides customers with wireless broadband Internet access.

The processor is the control center of the electronic device. It uses various interfaces and lines to connect the various parts of the entire mobile phone. By running or executing software programs and/or modules stored in the memory and calling data stored in the memory, the processor performs various functions of the electronic device and processes data, thereby performing overall monitoring of the mobile phone.

The electronic device also includes a power supply (such as a battery) to power various components. Preferably, the power supply may be logically connected to the processor through a power management system, so that the power management system can manage charging, discharging, and power consumption.

The electronic device may also include a camera, a Bluetooth module, etc., which will not be described in detail here. In some embodiments, the processor in the server may load the executable files corresponding to one or more application programs into the memory and execute the application programs stored in the memory, thereby implementing the followings:
receiving battery status information from a CSC;
performing enhancement processing on the battery status information to obtain enhanced battery status information; and
transmitting the enhanced battery status information to the BMU, so that the BMU controls the operating condition of the battery based on the enhanced battery status information.

In one embodiment, the server may also implement the following:
filtering and/or amplifying the battery status information to obtain filtered and/or amplified battery status information.

In one embodiment, the server may also implement the following:
adjusting the baud rate of the enhanced battery status information so that the baud rate of the enhanced battery status information is adapted to the communication network.

In one embodiment, the server may also implement the following:
the battery status information including at least one of the temperature information of the battery module or the voltage information of the battery module.

In one embodiment, the server may also implement the followings:
acquiring the signal power of battery status information; and
determining whether to perform enhancement processing on the battery status information based on the signal power.

In one embodiment, the server may also implement the followings:
receiving instruction information from a BMU;
performing enhancement processing on the instruction information to obtain enhanced instruction information; and
transmitting the enhanced instruction information to the CSC, so that the CSC executes the enhanced instruction information.

In one embodiment, the server may also implement the following:
filtering and/or amplifying the instruction information to obtain filtered and/or amplified instruction information.

In one embodiment, the server may also implement the following:
adjusting the baud rate of the enhanced instruction information so that the baud rate of the enhanced instruction information is adapted to that of the communication network.

In one embodiment, the server may also implement the followings:
acquiring the signal power of the instruction information; and
determining whether to perform enhancement processing on the instruction information based on the signal power.

In the above embodiments, the description of each embodiment has its own focus. For the part that is not described in detail in a certain embodiment, please refer to the detailed description above and will not be repeated here.

A person having ordinary skill in the art will appreciate that all or part of the operations in the various methods of the above embodiments can be accomplished via instructions or by controlling related hardware. The instructions can be stored in a medium and loaded and executed by a processor to perform the operations of the communication methods for the BMS provided in the embodiments of the present invention. The medium may be a computer-readable storage medium, which may be either non-volatile or volatile. The computer-readable storage medium may include read-only memory (ROM), random access memory (RAM), a magnetic disk, or an optical disk.

In one embodiment, the medium stores a plurality of instructions, which can be loaded by a processor to implement the followings:
receiving battery status information from a CSC;
performing enhancement processing on the battery status information to obtain enhanced battery status information; and
transmitting the enhanced battery status information to the BMU, so that the BMU controls the operating condition of the battery based on the enhanced battery status information.

In one embodiment, the processor may further implement the following:
filtering and/or amplifying the battery status information to obtain filtered and/or amplified battery status information.

In one embodiment, the processor may further implement the following:
adjusting the baud rate of the enhanced battery status information so that the baud rate of the enhanced battery status information is adapted to the communication network.

In one embodiment, the processor may further implement the following:
the battery status information including at least one of the temperature information of the battery module or the voltage information of the battery module.

In one embodiment, the processor may further implement the followings:
acquiring the signal power of battery status information; and
determining whether to perform enhancement processing on the battery status information based on the signal power.

In one embodiment, the processor may further implement the following:
receiving instruction information from a BMU;
performing enhancement processing on the instruction information to obtain enhanced instruction information; and
transmitting the enhanced instruction information to the CSC, so that the CSC executes the enhanced instruction information.

In one embodiment, the processor may further implement the following:
filtering and/or amplifying the instruction information to obtain filtered and/or amplified instruction information.

In one embodiment, the processor may further implement the following:
adjusting the baud rate of the enhanced instruction information so that the baud rate of the enhanced instruction information is adapted to that of the communication network.

In one embodiment, the processor may further implement the followings:
acquiring the signal power of the instruction information; and
determining whether to perform enhancement processing on the instruction information based on the signal power.

The storage medium may include: a read-only memory (ROM), a random access memory (RAM), a magnetic disk or an optical disk, etc.

The communication method for the BMS, BMS, electronic device and medium provided in the embodiments of the invention are introduced in detail above. Specific examples are used herein to illustrate the principles and implementations of the invention.

## Claims

1. A communication method for a battery management system (BMS) applicable to a relay unit of the BMS, the BMS comprising at least one cell supervision circuit (CSC) and a battery management unit (BMU), wherein the at least one CSC, the BMU, and the relay unit are connected to a same communication network, and wherein the communication method for the BMS comprises:
receiving battery status information from the at least one CSC;
performing enhancement processing on the battery status information to obtain enhanced battery status information; and
transmitting the enhanced battery status information to the BMU, so that the BMU controls an operating condition of a battery based on the enhanced battery status information.

2. The communication method for the BMS according to claim 1, wherein the performing of enhancement processing on the battery status information to obtain enhanced battery status information comprises:
filtering and/or amplifying the battery status information to obtain filtered and/or amplified battery status information.

3. The communication method for the BMS according to claim 1, wherein the performing enhancement processing on the battery status information to obtain the enhanced battery status information further comprises:
adjusting a baud rate of the enhanced battery status information so that the baud rate of the enhanced battery status information is adapted to the communication network.

4. The communication method for the BMS according to any one of claims 1 to 3, wherein the battery status information comprises at least one of temperature information or a voltage information of a battery module.

5. The communication method for the BMS according to any one of claims 1 to 3, wherein subsequent to the receiving the battery status information from the at least one CSC, the communication method further comprises:
acquiring a signal power of the battery status information; and
determining whether to perform enhancement processing on the battery status information based on the signal power.

6. A communication method for a battery management system (BMS), applicable to a relay unit of the BMS, the BMS comprising at least one cell supervision circuit (CSC) and a battery management unit (BMU), the at least one CSC, the BMU , and the relay unit being connected to a same communication network, wherein the communication method for the BMS comprises:
receiving instruction information from the BMU;
performing enhancement processing on the instruction information to obtain enhanced instruction information; and
transmitting the enhanced instruction information to the at least one CSC, so that the at least one CSC executes the enhanced instruction information.

7. The communication method for the BMS according to claim 6, wherein the performing enhancement processing on the instruction information to obtain enhanced instruction information comprises:
filtering and/or amplifying the instruction information to obtain filtered and/or amplified instruction information.

8. The communication method for the BMS according to claim 6, wherein the performing of enhancement processing on the instruction information to obtain enhanced instruction information further comprises:
adjusting a baud rate of the enhanced instruction information so that the baud rate of the enhanced instruction information is adapted to the communication network.

9. The communication method for the BMS according to any one of claims 6 to 8, wherein subsequent to the receiving instruction information from the BMU, the communication method further comprises:
acquiring a signal power of the instruction information; and
determining whether to perform enhancement processing on the instruction information based on the signal power.

10. A battery management system (BMS), comprising:
at least one cell supervision circuit (CSC), connected to a communication network;
a battery management unit (BMU), connected to the communication network;
a relay unit, connected to the communication network and disposed between the BMU and the at least one CSC, the relay unit being configured to implement the communication method for the BMS according to any one of claims 1 to 8.

11. The BMS according to claim 10, wherein the relay unit is disposed in a middle section of the communication network.

12. The BMS according to claim 10 or 11, wherein the relay unit comprises a casing, a repeater, and a connector, wherein the repeater is disposed in the casing, the connector is provided on the casing, one end of the connector is connected to the repeater and another end of the connector is connected to the communication network.

13. The BMS according to claim 12, wherein the casing comprises a housing and a cover, wherein the cover is sealed to the housing via a seal.

14. The BMS according to claim 13, wherein the casing further comprises a fixing seat connected to a bottom of the housing.

15. The BMS according to claim 12, wherein the connector comprises a first connector and a second connector, wherein the first connector has an end connected to the repeater and another end connected to the communication network, and the second connector has an end disconnected from the repeater and another end connected to the communication network.

16. An electronic device, comprising a memory and a processor, wherein the memory stores an application program, and the processor is configured to execute the application program in the memory to implement the communication method for the BMS according to any one of claims 1 to 9.

17. A computer-readable storage medium, having a computer program stored thereon, wherein the computer program is executed by a processor to implement the communication method for the BMS according to any one of claims 1 to 9.
